# EUROPEAN PATENT SPECIFICATION

(11) **EP 4 550 693 B1**
(45) Date of publication and mention of the grant of the patent: **15.07.2026**
(21) Application number: 25164949.7
(22) Date of filing: 08.08.2022
(51) Int. Cl.: H04B 10/40, H04B 10/2507, H04B 10/50, H04B 10/58

(54) **LASER TRANSMISSION CIRCUIT, LASER TRANSMISSION ASSEMBLY, AND ELECTRONIC MEASUREMENT INSTRUMENT**
LASERÜBERTRAGUNGSSCHALTUNG, LASERÜBERTRAGUNGSANORDNUNG UND ELEKTRONISCHES MESSINSTRUMENT
CIRCUIT DE TRANSMISSION LASER, ENSEMBLE DE TRANSMISSION LASER ET INSTRUMENT DE MESURE ÉLECTRONIQUE

(30) Priority: 27.06.2022 CN 202210739100; 27.06.2022 CN 202210738947
(43) Date of publication of application: 07.05.2025
(62) Divisional of application: 22948829.1
(73) Proprietor: Shenzhen Micsig Technology Co., Ltd., Shenzhen, Guangdong 518000 (CN)
(72) Inventor: ZHANG, Xingjie, Guangdong, 518000 (CN); WANG, Guanqun, Guangdong, 518000 (CN)
(74) Representative: Osterhoff, Utz

(56) References cited:
- US-A1- 2015 241 543
- US-A1- 2020 295 850
- US-B2- 7 466 925

## Description

### TECHNICAL FIELD

The present application relates to the technical field of laser signal transmission, and in particular to a laser transmission circuit, a laser transmission component and an electronic measuring instrument.

### BACKGROUND

At present, laser signal transmission is typically achieved through using laser diodes. However, the transmission of laser signals is highly susceptible to environmental factors or device operating conditions, resulting in instability. Consequently, this instability causes significant errors in the transmission of analog signals.

US7466925B2 discloses an optical transmitter for generating a modulated optical signal for transmission over dispersive fiber optic links in which a broadband analog radio frequency signal input is applied to a modulation circuit for directly modulating a semiconductor laser with the analog signal input. The transmitter may further include a temperature sensor in proximity to the laser and a negative feedback control circuit coupled to the temperature sensor for adjusting the temperature of the laser in response to an output characteristic of the laser, such as linearity.

US20200295850A1 relates to a digital low frequency correction circuit and a corresponding method for correction of low frequency disturbances within a digital signal, in particular to a reduction of distortions caused by analog circuitry, such as analog signal amplifiers. The low frequency correction circuit comprises a main signal path adapted to delay a digital input signal received by a signal input terminal and at least one correction signal path including a digital correction filter adapted to filter the received digital input signal. Furthermore, an adder of the circuit is adapted to add the digital signal delayed by the main signal path and the digital signal corrected by said correction signal path to generate a digital output signal output by a signal output terminal of the circuit.

### SUMMARY

The present application aims at solving the problem of errors caused by laser signals to analog signals during transmission.

The present application is set out in the appended set of claims.

The technical solution of the present application enables the abnormal low-frequency component in the output analog signal to be corrected in real time to a standard low-frequency component that is not affected by the above-mentioned influencing factors. The intermediate-frequency component and the high-frequency component themselves are not affected. Therefore, the corrected output analog signal can be regarded as not being affected by the above-mentioned influencing factors during the laser transmission process. Thereby, linear laser transmission of the analog signal is realized, and the problem that the laser signal causes errors to the analog signal during transmission due to the influence of the above-mentioned influencing factors is solved. In addition, the technical solution of the present application further enables electronic measuring instruments such as oscilloscopes to adopt the solution of laser transmission of analog signals, which overcomes the difficulties of the electronic measurement industry in adopting laser transmission of analog signals, improves the diversity of analog signal transmission, and is further conducive to improving the display accuracy of electronic measuring instruments for analog signals.

### BRIEF DESCRIPTION OF THE DRAWINGS

FIG. 1 is a schematic diagram of a module according to an embodiment of the present application.
FIG. 2 is a schematic diagram of a module of an analog emission unit according to an embodiment of the present application.
FIG. 3 is a circuit diagram of an analog emission unit according to an embodiment of the present application.
FIG. 4 is a circuit diagram of a drive module according to an embodiment of the present application.
FIG. 5 is another module schematic diagram according to an embodiment of the present application.
FIG. 6 is a schematic diagram of four circuits of an analog receiving unit according to an embodiment of the present application.
FIG. 7 is a schematic diagram of three modules of the signal processing unit according to an embodiment of the present application.

### DETAILED DESCRIPTION OF THE EMBODIMENTS

Below is a clear and complete description of the technical solutions in the embodiments of the present application with reference to the drawings in the embodiments of the present application. It is evident that the described embodiments are merely part of the embodiments of the present application, not all of them. Based on the embodiments in the present application, all other embodiments obtained by those skilled in the art without creative efforts shall fall within the scope of protection of the present application.

Additionally, in the present application, the description involving "first", "second", and the like is solely for descriptive purposes and should not be construed as indicating or implying relative importance or implicitly specifying the quantity of technical features indicated. Therefore, features defined as "first" or "second" may explicitly or implicitly include at least one of those features. Furthermore, the technical solutions in various embodiments can be combined with each other, provided that those of ordinary skill in the art can implement them. When a combination of technical solutions results in contradictions or cannot be implemented, it should be considered that such a combination does not exist and is not within the scope of protection required by the present application.

The present application provides a laser transmission circuit.

In the linear transmission of laser signals, two laser diodes, laser emission tube D1 and laser receiving tube D2, are usually required. The laser emission tube D1 can output the corresponding analog signal in the form of laser according to the accessed analog electrical signal, that is, the analog laser signal. In actual use, it is found that the laser signal is easily affected by the laser diode, especially the laser emission tube and the transmission environment during the transmission process. As a result, the analog laser signal output according to the low-frequency component in the analog electrical signal has errors, which leads to an offset in the low-frequency component of the analog electrical signal restored by the laser receiving tube D2 in the receiving unit 30. In this way, for electronic device, especially electronic measuring device such as oscilloscopes that have multiple signal transmission links, the offset of the low-frequency components generated in each signal transmission link will be superimposed in turn. Ultimately, the obtained analog electrical signal has extremely low accuracy, which is precisely the difficulty that the current electronic measurement industry cannot use laser signals to transmit analog signals. It should be noted that the sources of influence of the laser emission tube and the laser receiving tube may include but are not limited to: operating temperature and jitter of the applied instrument. The sources of influence of the transmission environment may include but are not limited to: ambient temperature, ambient light, ambient humidity, and transmission fiber jitter.

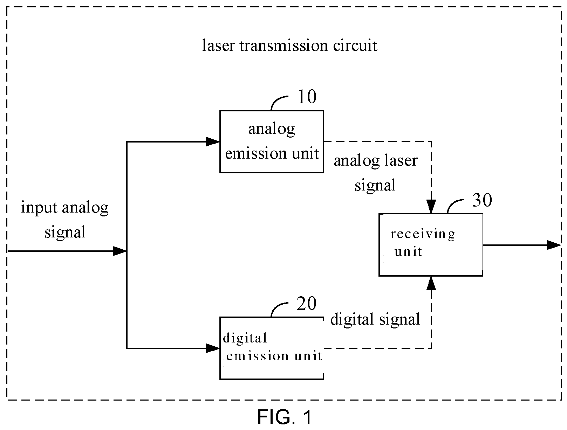

In view of the above problem, as shown in FIG. 1, according to an embodiment of the present application, the laser transmission circuit includes an analog emission unit, a digital emission unit, and a receiving unit.

An input end of the analog emission unit 10 is configured to access an input analog signal of the laser transmission circuit, and emit an analog laser signal corresponding to the input analog signal.

An input end of the digital emission unit 20 is configured to receive an input analog signal of the laser transmission circuit, and emit a digital signal corresponding to a low-frequency component of the input analog signal.

The receiving unit 30 is configured to receive the analog laser signal output by the analog emission unit 10 and the digital signal output by the digital emission unit 20 and to generate digital electrical signals and analog electrical signals respectively.

The receiving unit 30 is further used to correct the generated analog electrical signal according to the generated digital electrical signal, and output the corrected analog electrical signal.

In an embodiment, the input end of the analog emission unit 10 can be connected to the input end of the laser transmission circuit to access the analog electrical signal to be transmitted, that is, the input analog signal. And according to the input analog signal, an analog signal in the form of a laser can be output, that is, an analog laser signal, to be received by the receiving unit 30. It should be noted that the analog laser signal output by the analog emission unit 10 has all the signal components of the input analog signal.

The input end of the digital emission unit 20 can be connected to the input end of the laser transmission circuit to access the input analog signal to be transmitted and separate the low-frequency component therein. According to the separated low-frequency component, a digital signal of a corresponding form can be emitted to be received by the receiving unit 30. It should be noted that the input analog signal has three signal components: a low-frequency component, an intermediate-frequency component and a high-frequency component. In other words, the digital signal transmitted by the digital emission unit 20 has the low-frequency component of the input analog signal.

The receiving unit 30 can receive the analog laser signal through the laser receiving tube D2. And the digital receiving unit 32 such as the wireless receiving unit, the laser receiver, the wired receiving unit or the main controller can receive the digital signal in the corresponding form. And the received analog laser signal and digital signal can be converted into analog electrical signals and digital electrical signals in the form of electrical signals respectively. The analog electrical signal is corrected by the digital electrical signal. It should be noted that. Since the analog electrical signal corresponds to all signal components of the input analog signal. The digital electrical signal corresponds to the low-frequency component of the input analog signal. And since the digital emission unit 20 transmits the digital signal in the corresponding form and the receiving unit 30 converts the received digital signal into a digital electrical signal, the working process will not be affected by the laser diode and the transmission environment. Therefore, the digital electrical signal can be characterized as a standard low-frequency component that is not affected by the above. Therefore, the receiving unit 30 can determine the low-frequency offset of the low-frequency component in the input analog signal after being affected by the signal processing of the analog electrical signal and the digital electrical signal. And the low-frequency component in the analog electrical signal can be corrected by using the determined low-frequency offset. Specifically, the abnormal low-frequency component after being affected is obtained according to the analog electrical signal. And the corresponding standard low-frequency component is obtained according to the digital electrical signal. The abnormal low-frequency component can be compared with the standard low-frequency component to determine the low-frequency offset. The receiving unit can further perform corresponding operations on the low-frequency offset and the abnormal low-frequency component in the analog electrical signal until the abnormal low-frequency component in the analog electrical signal can be corrected to the standard low-frequency component.

As such, by repeating the above process, the abnormal low-frequency component in the analog electrical signal can be corrected in real time to a standard low-frequency component that is not affected by the laser diode and the transmission environment, and the intermediate-frequency component and the high-frequency component themselves are not affected. Therefore, the corrected analog electrical signal can be regarded as not being affected by the laser diode and the transmission environment during the laser transmission process. And it can be output as the output signal of the laser transmission circuit (hereinafter "output analog signal" means "output signal of the laser transmission circuit"). Thereby, linear laser transmission of the analog signal is realized, and the problem of the error caused by the laser signal to the analog signal during transmission is solved. In addition, the technical solution of the present application also enables electronic measuring instruments such as oscilloscopes to adopt the solution of laser transmission of analog signals, which overcomes the difficulties of the electronic measurement industry in adopting laser transmission of analog signals, improves the diversity of analog signal transmission, and is conducive to improving the display accuracy of electronic measuring instruments for analog signals.

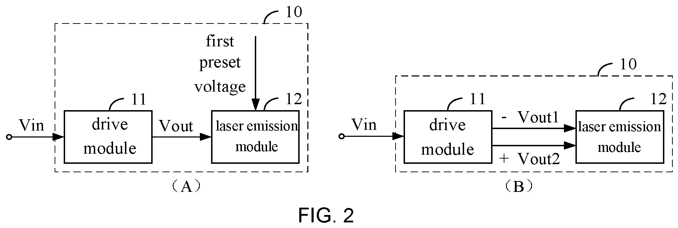

As shown in FIG. 2, according to an embodiment of the present application, the analog emission unit 10 includes: a drive module 11, and a laser emission module 12.

An input end of the drive module 11 is connected to the input end of the analog emission unit 10.

The first end of the laser emission module 12 is connected to the output end of the drive module 11. The second end of the laser emission module 12 is configured to access a first preset voltage. Or, the first end of the laser emission module 12 is connected to the positive output end of the drive module 11. The second end of the laser emission module 12 is connected to the negative output end of the drive module 11 to access the differential signal output by the drive module 11.

In an embodiment, the drive module 11 is configured to perform operational amplification on the input analog signal and then output it to the laser emission module 12, so as to drive the laser emission module 12 to emit an analog laser signal. Two driving manners of the drive module 11 to drive the laser emission module 12 are provided here: the first driving manner can be specifically referred to FIG. 2 (A). The drive module 11 outputs a single-ended signal (Vout) to the first end of the laser emission module 12, so that the laser emission module 12 can emit a corresponding analog laser signal according to the single-ended signal (Vout) and the first preset voltage respectively accessed to the two ends. The second driving manner can be specifically referred to FIG. 2 (B). The drive module 11 outputs a differential signal (Vout1 and Vout2) to the two ends of the laser emission module 12, so that the laser emission module 12 can emit a corresponding analog laser signal according to the differential signal (Vout1 and Vout2) accessed to the two ends.

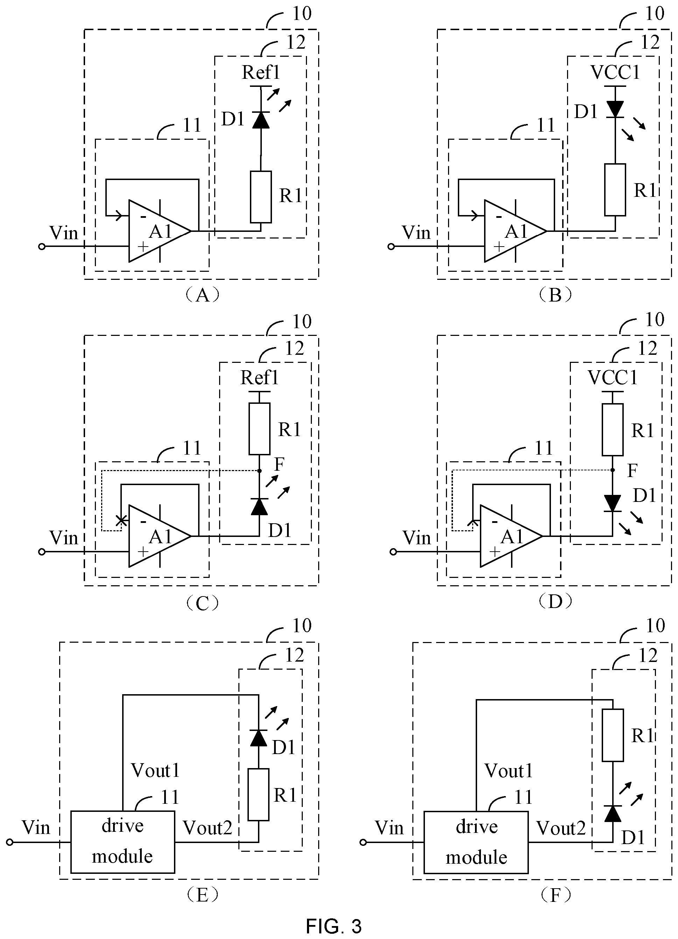

In an embodiment, the laser emission module 12 includes a laser emission tube D1 and a first resistor R1. When the output signal of the drive module 11 is a single-ended signal (Vout), the first preset voltage may be a first preset power supply voltage VCC1 or a first preset reference voltage Ref1. Two construction manners of the laser emission module 12 are provided here. The construction manner of the first laser emission module 12 can refer to (A) and (B) in FIG. 3. One of the anode and the cathode of the laser emission tube D1 can be accessed to the single-ended signal (Vout) output by the drive module 11 through the first resistor R1. The other of the anode and the cathode is accessed to the first preset voltage. Specifically, the anode of the laser emission tube D1 is accessed to the single-ended signal (Vout) through the first resistor R1. The cathode is accessed to the first preset reference voltage Ref1. Or, the cathode of the laser emission tube D1 is accessed to the single-ended signal (Vout) through the first resistor R1. The anode is accessed to the first preset power supply voltage VCC1. The construction manner of the second laser emission module 12 can refer to (C) and (D) in FIG. 3. One of the anode and cathode of the laser emission tube D1 is accessed to the single-ended signal (Vout) output by the drive module 11. The other of the anode and cathode can be accessed to the first preset voltage through the first resistor R1. Specifically: the anode of the laser emission tube D1 is accessed to the single-ended signal (Vout). The cathode can be accessed to the first preset reference voltage Ref1 through the first resistor R1. Or, the cathode of the laser emission tube D1 is accessed to the single-ended signal through the first resistor R1. The anode can be accessed to the first preset power supply voltage VCC1 through the first resistor R1.

When the output signal of the drive module 11 includes a first output signal (Vout1) and a second output signal (Vout2) that are differential signals. Two construction manners of the laser emission module 12 are further provided here. The first construction manner of the laser emission module 12 can be referred to (E) in FIG. 3. The cathode of the laser emission tube D1 is accessed to the first output signal (Vout1). The anode is accessed to the second output signal (Vout2) through the first resistor R1. Of course. It is also possible that the anode of the laser emission tube D1 is accessed to the first output signal (Vout1). The cathode is accessed to the second output signal (Vout2) through the first resistor R1. The second construction manner of the laser emission module 12 can be referred to (F) in FIG. 3. The cathode of the laser emission tube D1 is accessed to the first output signal (Vout1) through the first resistor R1. The anode is accessed to the second output signal (Vout2). Of course. It is also possible that the anode of the laser emission tube D1 is accessed to the first output signal (Vout1) through the first resistor R1, and the cathode is accessed to the second output signal (Vout2).

In an embodiment, when the first end of the laser emission tube D1 is connected to the first end of the laser emission module 12, and the other end of the laser emission tube D1 is connected to the second end of the laser emission module 12 through the first resistor R1, the connection point between the laser emission tube D1 and the first resistor R1 is the end F, the drive module 11 includes a first amplifier circuit, and the first amplifier circuit has a non-inverting input end and an inverting input end.

In an embodiment, the first amplifier circuit can be implemented by an operational amplifier or an operational amplifier chip. In an embodiment, it can be implemented by an amplifier circuit constructed by discrete electronic devices such as triodes and resistors, which is not limited here. Here, the working principle of the drive module 11 is explained in detail by taking the implementation of the first amplifier circuit by an operational amplifier (hereinafter referred to as the first operational amplifier A1) as an example. The non-inverting input end of the first operational amplifier A1 can be the non-inverting input end of the first amplifier circuit, the inverting input end of the first operational amplifier A1 can be the inverting input end of the first amplifier circuit, and the output end of the first operational amplifier A1 can be the output end of the first amplifier circuit.

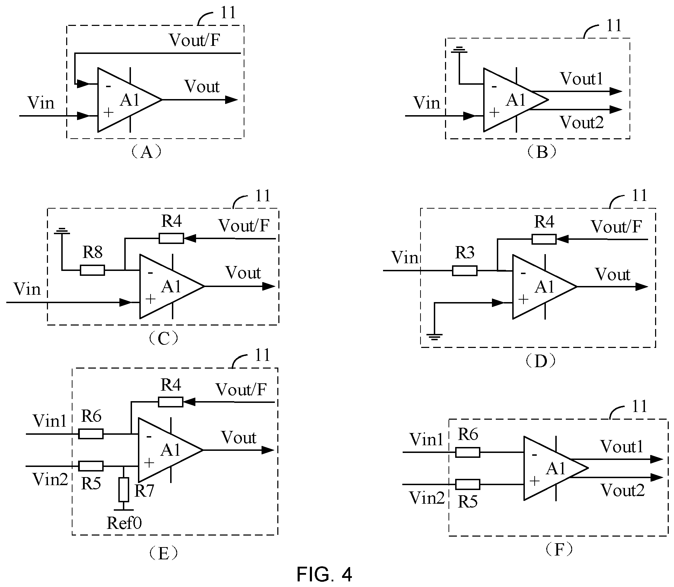

When the input analog signal is a single-ended signal (Vout), either the non-inverting input end or the inverting input end of the first operational amplifier A1 can be connected to the input analog signal of the single-ended signal through the third resistor R3. The resistance of the third resistor R3 is not less than 0Ω. When the non-inverting input end is configured to access the input analog signal, the resistance of the third resistor R3 can be selected as 0Ω or greater than 0Ω according to actual needs. At this time, the inverting input end can be connected to a preset reference voltage or connected to the ground through the eighth resistor R8. Specifically refer to (C) in FIG. 4. When the inverting input end is configured to access the input analog signal, the resistance of the third resistor R3 can be selected from a range greater than 0Ω according to actual needs. And at this time, the non-inverting input end can be connected to a preset reference voltage or connected to the ground, which can be specifically referred to (D) in FIG. 4.

The first operational amplifier A1 can perform operational amplification on the input analog signal connected. Output in the form of a single-ended signal or a differential signal, which can be specifically referred to (A) and (B) in FIG. 4 respectively. It should be noted that when the first operational amplifier A1 outputs a differential signal. When the input analog signal connected is a single-ended signal. The first operational amplifier's non-inverting/inverting input end that is not connected to the input analog signal can be connected to a preset reference voltage or ground. The inverting input end of the first operational amplifier A1 can be connected to the output end of the first operational amplifier A1 or the end F in the laser emission module 12 through the fourth resistor R4. The output signal connected to the first operational amplifier A1 or the signal at the end F is used as a feedback signal to realize the negative feedback regulation of the first operational amplifier A1, which is beneficial to improve the consistency between the output signal of the first operational amplifier A1 and the input analog signal, which can be specifically referred to (C) and (D) in FIG. 4. The resistance value of the fourth resistor is not less than 0Ω. The negative feedback path of the end F can refer to the dotted line path in (C) and (D) in FIG. 3. The negative feedback path of the output end of the first operational amplifier A1 can refer to the solid line path in (A), (B), (C), and (D) in FIG. 3. It should be noted that when the laser emission tube D1 is connected to the output end of the first operational amplifier A1 through the first resistor R1, there is no end F in the circuit. When the resistance value of the third resistor R3 and the fourth resistor R4 is 0Ω, they can be regarded as wires. Therefore, the third resistor R3 and the fourth resistor R4 are not shown in (A) and (B) in FIG. 3.

When the input analog signal is a differential signal. The non-inverting input end of the first operational amplifier A1 is accessed to the input analog signal through the fifth resistor R5 and the inverting input end of the first operational amplifier A1 is accessed to the input analog signal through the sixth resistor R6. The non-inverting input end is connected to the preset reference voltage RER0 through the seventh resistor R7. At this time, the input analog signal may include a first input analog signal (Vin1) and a second input analog signal (Vin2) which are differential signals. The first operational amplifier A1 can perform operational amplification on the accessed first input analog signal (Vin1) and the second input analog signal (Vin2), and output them in the form of a single-ended signal (Vout) or a differential signal (Vout1 and Vout2), which can be specifically referred to (E) and (F) in FIG. 4 respectively. It should be noted that, when the first operational amplifier A1 outputs the differential signal (Vout1 and Vout2), the first operational amplifier A1 does not have a negative feedback path.

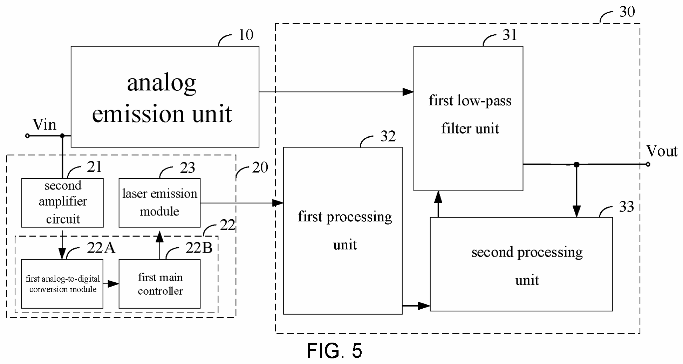

As shown in FIG. 5, in the first embodiment of the present application, the digital emission unit 20 includes a first low-pass filter unit 21, a first main control unit 22 and a digital emission module 23. The input end of the first low-pass filter unit 21 is the input end of the digital emission unit 20. The output end of the first low-pass filter unit 21 is connected to the controlled end of the digital emission module 23 through the first main control unit 22.

In an embodiment, the first main control unit 22 can be a microprocessor or main control chip such as MCU, DSP, FPGA, etc. that has an analog-to-digital conversion function, which is not limited here. The input end of the first low-pass filter unit 21 can be the input end of the digital emission unit 20. The first low-pass filter unit 21 is configured to low-pass filter the input analog signal accessed to the laser transmission circuit, and output the low-frequency component in the input analog signal to the analog input end of the first main control unit 22. After the driving signal converted into a digital electrical signal by the first main control unit 22, it is output to the controlled end of the digital emission module 23. So that the digital emission module 23 can transmit the corresponding digital signal according to the received driving signal, thereby realizing the transmission of digital signals. The digital signal can be a laser signal, an electromagnetic wave signal, an electrical signal or an optical signal, etc.

In an embodiment, the first main control unit 22 includes a first main controller 22B and a first analog-to-digital conversion module 22A. The first low-pass filter unit 21 is connected to the controlled end of the digital transmission module 23 through the first analog-to-digital conversion module 22A and the first main controller 22B.

In an embodiment, the first main controller 22B can output the driving signal of the analog electrical signal to the first analog-to-digital conversion module 22A according to the low-frequency component output by the first low-pass filter unit 21. After being converted into the driving signal of the digital electrical signal by the first analog-to-digital conversion module 22A, it is output to the digital emission module 23. Thus, the driving of the digital emission module 23 is realized. In short, it can be regarded as using the first analog-to-digital conversion module 22A to realize the analog-to-digital conversion function of the first main controller 22B. Since the digital electrical signal is configured to drive the digital emission module 23 to work, the working condition of the digital emission module 23 can be effectively prevented from being affected by the laser diode and the transmission environment. And then the digital signal transmission is affected, which is conducive to improving the stability of the digital signal process. In addition, it is relatively easy for the first main control unit 22 or the first analog-to-digital conversion module 22A to achieve high precision in practical applications. Therefore, it is also conducive to reducing the difficulty of high-precision realization of standard low-frequency components.

As shown in FIG. 5, in the first embodiment of the present application, the receiving unit 30 includes: an analog receiving unit 31, a digital receiving unit 32, and a signal processing unit 33.

The analog receiving unit 31 is configured to receive the analog laser signal and output an analog electrical signal.

The digital receiving unit 32 is configured to receive the digital signals and output the digital electrical signals.

A first input end of the signal processing unit 33 is connected to the output end of the analog receiving unit 31 and a second input end of the signal processing unit 33 is connected to the output end of the digital receiving unit 32. The signal processing unit 33 is configured to perform signal process on the accessed analog electrical signal and the digital electrical signal, and output a low-frequency correction signal to the feedback end of the analog receiving unit 31.

The analog receiving unit 31 is further used to correct the low-frequency operating point according to the received low-frequency correction signal, and output an analog electrical signal corresponding to the corrected low-frequency operating point.

In an embodiment, the analog receiving unit 31 can receive the analog laser signal through the laser receiving tube D2, generate a corresponding analog electrical signal according to the analog laser signal, and the analog electrical signal can be amplified and output as an output analog signal. It should be noted that the low-frequency offset of the low-frequency component in the output analog signal can be adjusted by changing the low-frequency operating point of the analog receiving unit 31. Specifically, when the output analog signal is affected by the laser diode and the transmission environment so that the voltage value corresponding to the low-frequency component is greater than the unaffected normal voltage value, the voltage value corresponding to the low-frequency component in the output analog signal can be restored to the normal voltage value by lowering the low-frequency operating point. When the output analog signal is affected by the laser diode and the transmission environment so that the voltage value corresponding to the low-frequency component is less than the unaffected normal voltage value, the voltage value corresponding to the low-frequency component in the output analog signal can be restored to the normal voltage value by raising the low-frequency operating point.

The digital receiving unit 32 can receive digital signals in the form of laser signals, electromagnetic wave signals, electrical signals or optical signals through a digital receiver, and can generate and output corresponding digital electrical signals according to the digital signals.

The first input end and the second input end of the signal processing unit 33 can be connected to the output end of the analog receiving unit 31 and the output end of the digital receiving unit 32 in a one-to-one correspondence, so as to respectively access the output analog signal and the digital electrical signal, and the abnormal low-frequency component in the output analog signal can be separated. It can be understood that the abnormal low-frequency component corresponds to the low-frequency component affected by the laser diode and the transmission environment, and the digital electrical signal corresponds to the standard low-frequency component not affected by the laser diode and the transmission environment. Therefore, the signal processing unit 33 can determine the degree of deviation of the abnormal low-frequency component according to the abnormal low-frequency component and the standard low-frequency component. And according to the determination result, the corresponding electrical signal can be output to increase or decrease the low-frequency operating point of the analog receiving unit 31 accordingly, so that the analog receiving unit 31 can re-perform the corresponding operation on the analog electrical signal accordingly and output it as a new output analog signal based on the low-frequency operating point after being raised or lowered. As such, by repeating the above process, the signal processing unit 33 can adjust the low-frequency operating point of the analog receiving unit 31 in real time, so that the analog receiving unit 31 can continuously output the output analog signal with the low-frequency component unaffected.

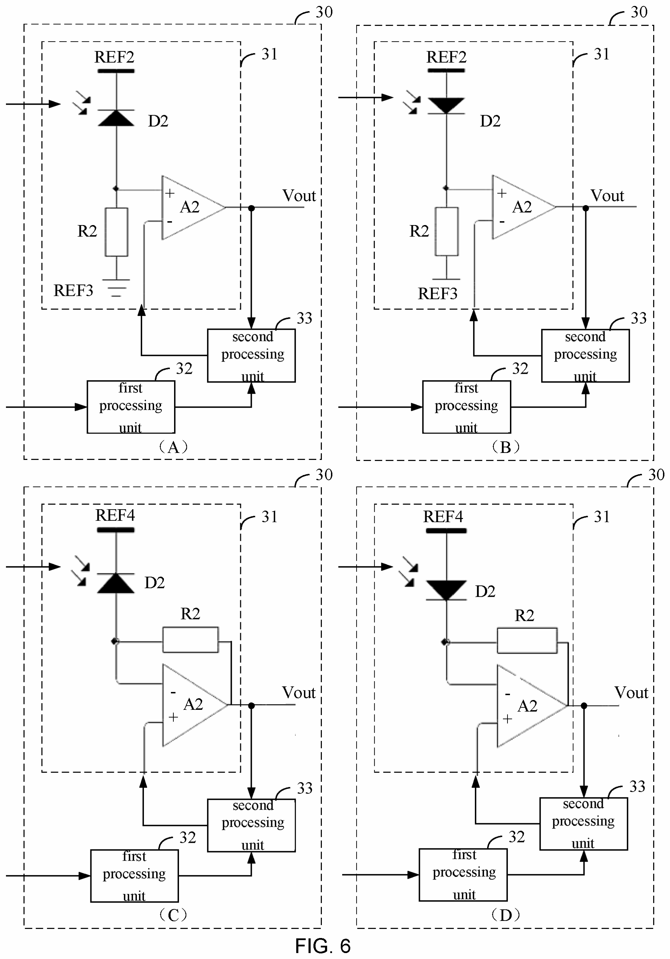

As shown in (A) and (B) in FIG. 6, in the first embodiment of the present application, the analog receiving unit 31 includes: a laser receiving tube D2, a second resistor R2, and a second amplifier circuit.

The first electrode of the laser receiving tube D2 is configured to access the second preset voltage. The second electrode of the laser receiving tube D2 is connected to the first input end of the second amplifier circuit. The second electrode of the laser receiving tube D2 is further connected to the third preset voltage through the second resistor R2. The second input end of the second amplifier circuit is the feedback end of the analog receiving unit 31. The output end of the second amplifier circuit is the output end of the analog receiving unit 31.

In an embodiment, the second amplifier circuit can be implemented by an operational amplifier or an operational amplifier chip. In an embodiment, it can be implemented by an amplifier circuit constructed by discrete devices such as triodes and resistors, which is not limited here. The working principle of the analog receiving unit 31 is explained in detail by taking the implementation of the second amplifier circuit by an operational amplifier (hereinafter referred to as the second operational amplifier A2) as an example. The non-inverting input end, the inverting input end and the output end of the second operational amplifier A1 can be the first input end, the inverting input end and the output end of the second amplifier circuit, respectively.

The laser receiving tube D2 has an anode and a cathode. When the first electrode is an anode and the second electrode is a cathode, the second preset voltage RER2 is less than the third preset voltage RER3. The laser receiving tube D2 generates a corresponding induced current according to the received analog laser signal. The current flows to the laser receiving tube D2 through the second resistor R2. When the first electrode is a cathode and the second electrode is an anode, the second preset voltage RER2 is greater than the third preset voltage RER3. The laser receiving tube D2 generates a corresponding induced current according to the received analog laser signal, which flows to the third preset voltage RER3 through the second resistor R2. The voltage signal formed at the connection between the laser receiving tube D2 and the second resistor R2 is amplified by the second operational amplifier A2 and output as an output analog signal. It can be understood that, in an embodiment, the low-frequency operating point of the analog receiving unit 31 is the low-frequency operating point of the second operational amplifier A2, and is corrected by the low-frequency correction signal accessed to its inverting end.

As shown in (C) and (D) in FIG. 6, in the first embodiment of the present application, the analog receiving unit 31 includes: a laser receiving tube D2, a second resistor R2 and a second amplifier circuit.

The first electrode of the laser receiving tube D2 is configured to access the fourth preset voltage. The second electrode of the laser receiving tube D2 is connected to the second input end of the second amplifier circuit. The second electrode of the laser receiving tube D2 is further connected to the output end of the second amplifier circuit through the second resistor R2. The first input end of the second amplifier circuit is the feedback end of the analog receiving unit 31. The output end of the second amplifier circuit is the output end of the analog receiving unit 31.

When the first electrode of the laser receiving tube D2 is an anode and the second electrode is a cathode, the laser receiving tube D2 generates a corresponding induced current according to the received analog laser signal. The current flows from the output end of the second operational amplifier A2 through the second resistor R2 through the laser receiving tube D2. When the first electrode of the laser receiving tube D2 is a cathode and the second electrode is an anode, the laser receiving tube D2 generates a corresponding induced current according to the received analog laser signal and flows into the output end of the second operational amplifier A2 through the second resistor R2. It can be understood that, in an embodiment, the low-frequency operating point of the analog receiving unit 31 is the low-frequency operating point of the second operational amplifier A2, and is corrected by the low-frequency correction signal accessed to its non-inverting end.

It should be noted that the first preset voltage REF1, the second preset voltage RER2, the third preset voltage RER3, and the fourth preset voltage RER4 recorded in this specification can be obtained by outputting the power management circuit in the device. And the voltage values of the four preset voltages can be the same or different, which is not limited here. In an embodiment, the first preset voltage REF1, the second preset voltage RER2, the third preset voltage RER3, and the fourth preset voltage RER4 can be implemented using a ground voltage.

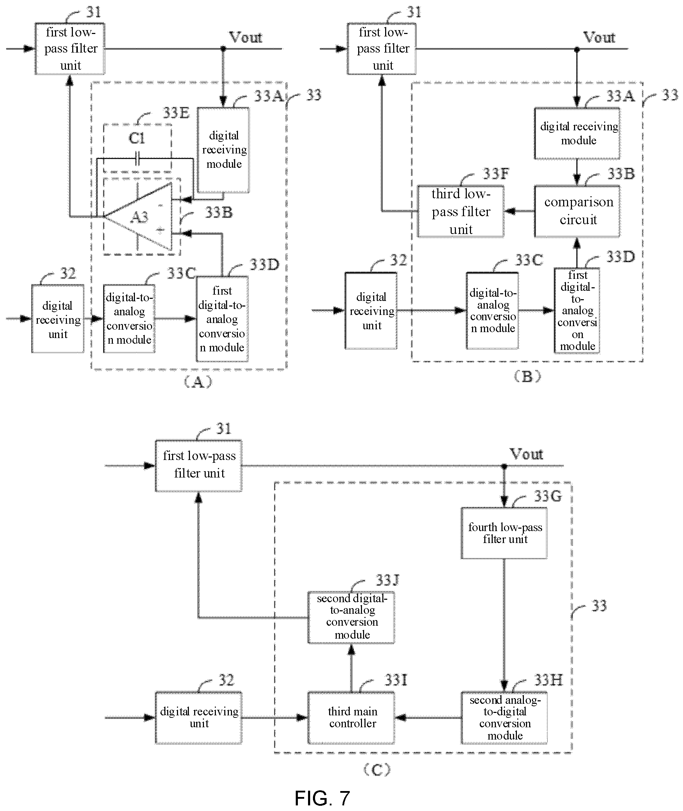

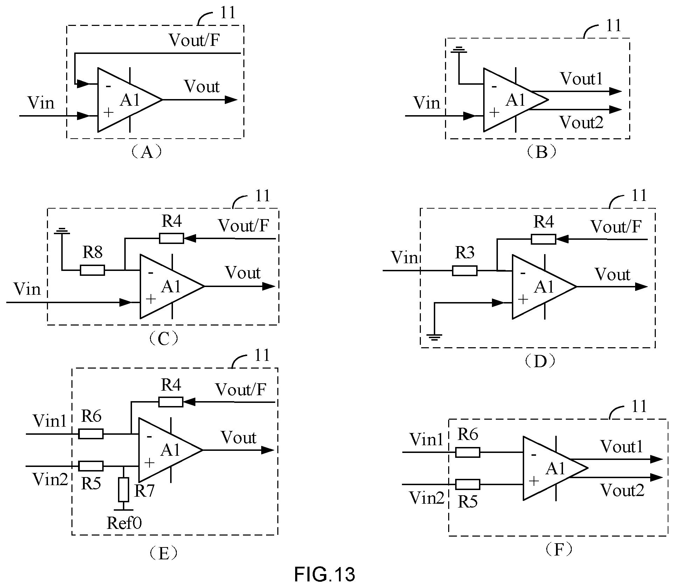

As shown in FIG. 7 (A), according to an embodiment of the present application, the signal processing unit 33 includes: a second low-pass filter unit 33A, a second main control unit and a comparison circuit 33B.

The input end of the second low-pass filter unit 33A is the first input end of the signal processing unit 33. The output end of the second low-pass filter unit is connected to the first input end of the comparison circuit 33B. The input end of the second main control unit is the second input end of the signal processing unit 33. The output end of the second main control unit is connected to the second input end of the comparison circuit 33B. The output end of the comparison circuit 33B is connected to the feedback end of the analog receiving unit 31.

The second low-pass filter unit 33A is configured to perform low-pass filtering on the output analog signal, so as to output the abnormal low-frequency component in the output analog signal to the first input end of the comparison circuit 33B. The second main control unit can be a main controller or a main control chip with an analog-to-digital conversion function. The main controller can be a microprocessor such as MCU, DSP, FPGA, etc. The second main control unit can perform signal processing and digital-to-analog conversion on the digital electrical signal output by the digital receiving unit 32 to an analog electrical signal representing a standard low-frequency component, and output to the second input end of the comparison circuit 33B. The comparison circuit 33B can compare and process the analog electrical signals connected to the first input end and the second input end respectively to obtain the low-frequency offset of the low-frequency component in the output analog signal, and can output the corresponding electrical signal (i.e., the low-frequency correction signal) to the feedback end of the analog receiving unit 31, thereby realizing the correction of the low-frequency operating point of the analog receiving unit 31.

In an embodiment, the comparison circuit 33B can be implemented by an amplifier circuit or a dedicated comparison chip; or, it can further be implemented by a comparison circuit constructed by a switch device and a discrete device. The specific implementation of the amplifier circuit (hereinafter referred to as the third amplifier circuit) can refer to the first amplifier circuit and the second amplifier circuit mentioned above, which will not be repeated herein. The working principle of the analog receiving unit 31 is explained in detail by taking the implementation of the third amplifier circuit by an operational amplifier (hereinafter referred to as the third operational amplifier A3) as an example. The non-inverting input end of the third operational amplifier A3 can be the non-inverting input end of the first amplifier circuit, the inverting input end of the third operational amplifier A3 can be the inverting input end of the first amplifier circuit and the output end of the third operational amplifier A3 can be the output end of the first amplifier circuit.

Any one of the non-inverting input end and the inverting input end of the third operational amplifier A3 can be the first input end of the comparison circuit 33B. The other can be the second input end. In the first embodiment, a capacitor circuit 33E is also connected between the first input end and the output end of the comparison circuit 33B. The capacitor circuit 33E may include at least one capacitor C to increase the working stability of the third operational amplifier A3.

In an embodiment, as shown in FIG. 7 (B), a low-pass filter unit may be connected between the output end of the comparison circuit 33B and the feedback end of the analog receiving unit 31, that is, the third low-pass filter unit 33F. The low-frequency correction signal output by the comparison circuit 33B is low-pass filtered and then output to the feedback end of the analog receiving unit 31 to ensure that there are no intermediate-frequency component and high-frequency component in the low-frequency correction signal received by the feedback end of the analog receiving unit 31, which is conducive to improving the stability of the low-frequency operating point correction of the analog receiving unit 31.

In an embodiment, the second main control unit includes: a second main controller 33C and a first digital-to-analog conversion module 33D. The input end of the second main controller 33C is the input end of the second main control unit. The output end of the second main controller 33C is connected to the input end of the first digital-to-analog conversion module 33D. The output end of the first digital-to-analog conversion module 33D is the output end of the second main control unit.

In an embodiment, the second main controller 33C can process the digital electrical signal output by the digital receiving unit 32 and output it to the first digital-to-analog conversion module 33D. After being converted by the first digital-to-analog conversion module 33D into an analog electrical signal, it is output to the signal processing unit 33. In short, it can be regarded as using the first digital-to-analog conversion module 33D to realize the analog-to-digital conversion function of the second main controller 33C.

As shown in FIG. 7 (C), in the first embodiment of the present application, the signal processing unit 33 includes: a fourth low-pass filter unit 33G and a third main control unit.

The input end of the fourth low-pass filter unit 33G is the first input end of the signal processing unit 33. The output end of the fourth low-pass filter unit 33G is connected to the second input end of the third main control unit. The second input end of the third main control unit is the second input end of the signal processing unit 33. The output end of the third main control unit is the output end of the analog receiving unit 31.

In an embodiment, the fourth low-pass filter unit 33G is configured to perform low-pass filtering on the output analog signal to output the abnormal low-frequency component in the output analog signal to the third main control unit. The third main control unit can be a main controller or a main control chip that has analog-to-digital conversion function and digital-to-analog conversion function. The main controller can be a microprocessor such as MCU, DSP, FPGA, etc. The third main control unit can directly access the digital electrical signal output by the digital receiving unit 32, and after the abnormal low-frequency component is converted into a digital signal through analog-to-digital conversion, the pre-integrated hardware circuit and software program or algorithm can be run to operate the two digital electrical signals to determine the low-frequency offset of the low-frequency component in the output analog signal. The third main control unit can further directly output the low-frequency correction signal of the analog electrical signal to the feedback end of the analog receiving unit 31 according to the determination result, thereby realizing the low-frequency operating point correction of the analog receiving unit 31.

In an embodiment, the third main control unit includes: a second analog-to-digital conversion module 33H, a third main controller 33I, and a second digital-to-analog conversion module 33J.

The third main controller 33I is connected to the output end of the digital receiving unit 32. The third main controller 33I is further connected to the output end of the analog receiving unit 31 through the second analog-to-digital conversion module 33H. The third main controller 331 is further connected to the feedback end of the analog receiving unit 31 through the second digital-to-analog conversion module 33J.

In an embodiment, the third main control unit may include: a second analog-to-digital conversion module 33H, a third main controller 331 and a second digital-to-analog conversion module 33J. The third main controller 33I may be directly connected to the output end of the digital receiving unit 32 to access the digital electrical signal output by the digital receiver. The second analog-to-digital conversion module 33H may be connected to the output end of the fourth low-pass filter unit 33G to convert the abnormal low-frequency component output by the fourth low-pass filter unit 33G into a digital signal and then output it to the third main controller 331. The third main controller 331 may perform corresponding operations on the two digital electrical signals to determine the low-frequency offset of the low-frequency component in the output analog signal, and the low-frequency correction signal of the digital electrical signal may be output to the second digital-to-analog conversion module 33J. After being converted into an analog electrical signal by the second digital-to-analog conversion module 33J, it is output to the feedback end of the analog receiving unit 31. In short, it can be regarded as using the second analog-to-digital conversion module 33H and the second digital-to-analog conversion module 33J to respectively realize the analog-to-digital conversion function and the digital-to-analog conversion function of the second main controller 33C. In addition, the second main control unit, the third main control unit, the first digital-to-analog conversion module 33D, the second digital-to-analog conversion module 33J and the second analog-to-digital conversion module 33H are less difficult to achieve high precision in actual applications, which is also conducive to reducing the difficulty of achieving high precision of low-frequency operating point correction.

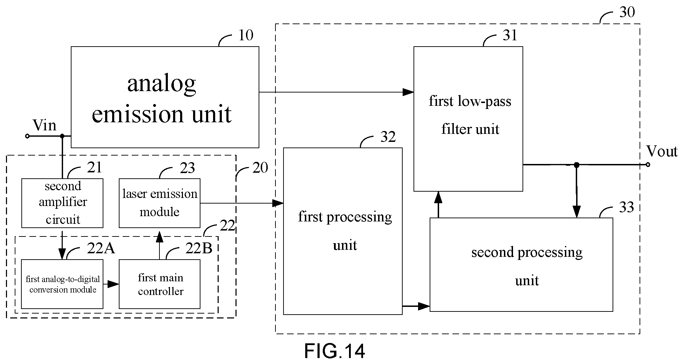

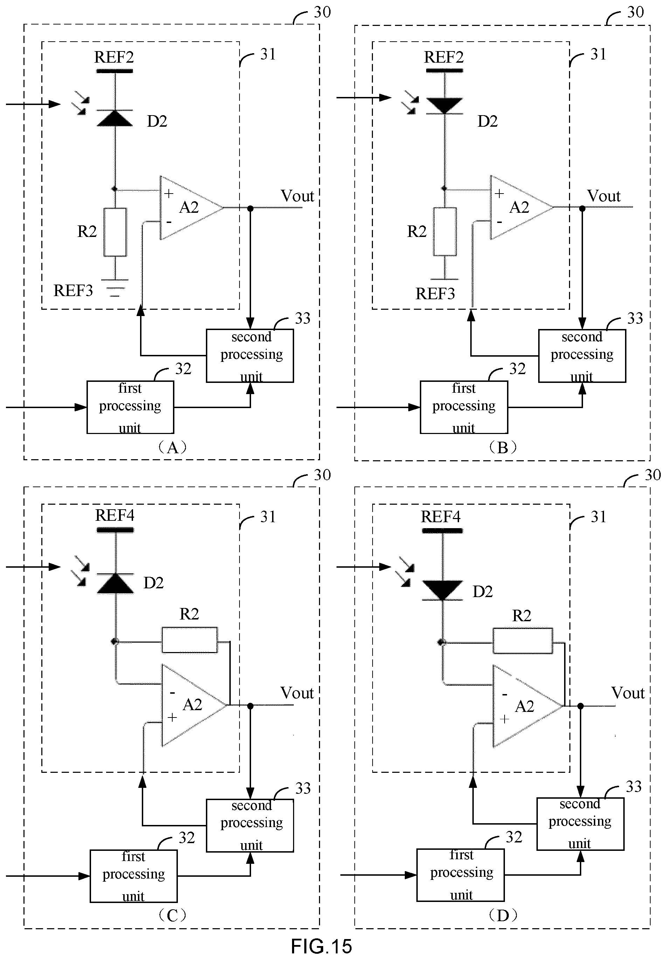

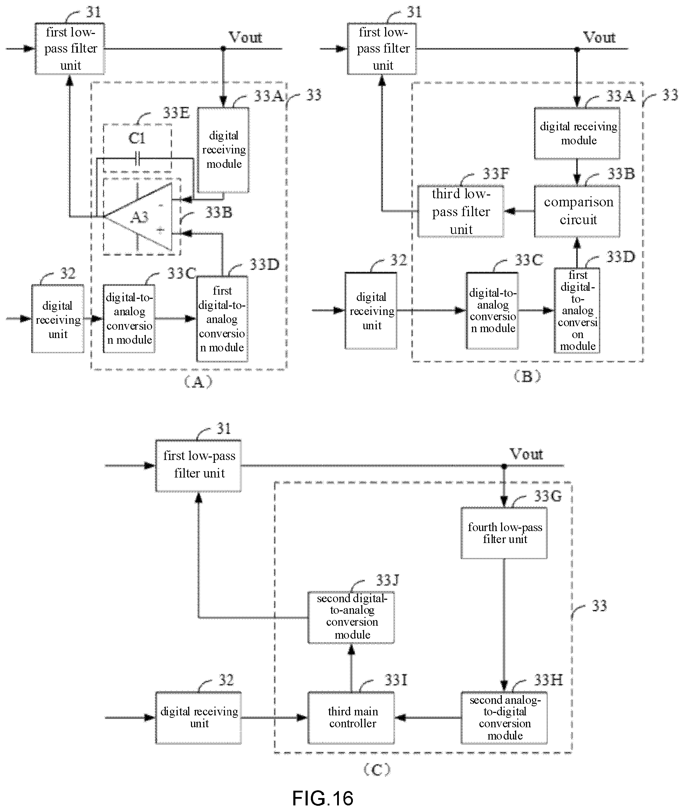

As shown in FIGS. 14 to 16, according to the first embodiment of the present application, the digital emission module 23 is a laser transmitter, and the digital receiving unit 32 is a laser receiver.

The laser transmitter can output a digital signal in the form of laser to the laser receiver under the drive of a digital electrical signal, so that the laser receiver can generate and output a corresponding digital electrical signal according to the received digital signal in the form of laser, thereby realizing laser transmission of low-frequency components. It should be noted that, since is it is driven by the digital electrical signal, the digital laser signal output by the laser transmitter will not be affected by the laser diode and the transmission environment, so that the laser receiver can restore the output without offset and represent the digital electrical signal of the standard low-frequency component.

In an embodiment, the digital emission module 23 is a wireless transmitting circuit, and the digital receiving unit 32 is a wireless receiving circuit.

The wireless transmitting circuit and the wireless receiving unit may be near-field communication circuits such as infrared communication circuits, Bluetooth communication circuits, ultra-wideband communication circuits, ZigBee communication circuits, and radio frequency identification (RFID) communication circuits. Or they may also be far-field communication circuits such as 3G communication circuits, 4G communication circuits, 5G communication circuits, Wi-Fi communication circuits, WiGig communication circuits, and wireless broadband Internet communication circuits, which is not limited here. The wireless transmitting circuit may be driven by a digital electrical signal to output a digital signal in the form of infrared, electromagnetic waves, etc., to the wireless receiving circuit, so that the wireless receiving unit can generate and output a corresponding digital electrical signal according to the received digital signal in the form of infrared, electromagnetic waves, etc., thereby realizing wireless communication transmission of low-frequency components.

In an embodiment, the digital emission module 23 is an opto-coupler unit. The digital receiving unit 32 is a main controller.

The opto-coupler unit can access the digital electrical signal output by the first analog-to-digital conversion module 22A through the primary side, and can generate and output a corresponding digital electrical signal through the secondary side under the drive of the digital electrical signal, thereby realizing optical communication transmission of the low-frequency component.

In an embodiment, the digital emission module 23 is a main controller, and the digital receiving unit 32 is an opto-coupler unit.

The main controller can access the digital electrical signal output by the first analog-to-digital conversion module 22A, and can output the digital electrical signal after signal processing, so as to be received and identified by the primary side of the opto-coupler unit in the receiving unit 30, thereby realizing the communication transmission of the low-frequency component.

### Second embodiment

The present application further provides a laser transmission component. The laser transmission component includes a laser transmission circuit. The specific structure of the laser transmission circuit refers to the above-mentioned embodiments. Since the laser transmission component adopts all the technical solutions of all the above-mentioned embodiments, it has at least all the beneficial effects brought by the technical solutions of the above-mentioned embodiments. No further description will be given here.

The laser transmission component may include an emission component and a receiving component. When the laser transmission component adopts the laser transmission circuit of the first embodiment, the analog emission unit 10 and the digital emission unit 20 may be provided in the emission component, and the receiving unit 30 may be provided in the receiving component. Thus, the laser transmission of the analog signal between the emission component and the receiving component can be realized.

The following will be combined with the drawings in the embodiments of the present application to clearly and completely describe the technical solutions in the embodiments of the present application. Obviously, the described embodiments are only part of the embodiments of the present application, not all of the embodiments.

## Claims

1. A laser transmission circuit, **characterized by** comprising:
an analog emission unit (10);
a digital emission unit (20); and
a receiving unit (30), wherein:
the analog emission unit (10) comprises an input end configured to receive an input analog electrical signal of the laser transmission circuit, and is configured to emit an analog laser signal corresponding to the input analog electrical signal;
the digital emission unit (20) comprises an input end configured to receive the input analog electrical signal of the laser transmission circuit, and is configured to emit a digital signal corresponding to a low-frequency component of the input analog electrical signal;
the receiving unit (30) is configured to receive the analog laser signal output by the analog emission unit (10) and the digital signal output by the digital emission unit (20), and generate an analog electrical signal corresponding to the analog laser signal and a digital electrical signal corresponding to the digital signal; and
the receiving unit (30) is further configured to correct the generated analog electrical signal according to the generated digital electrical signal, and output the corrected analog electrical signal.

2. The laser transmission circuit according to claim 1, wherein:
the analog emission unit (10) comprises a drive module (11) and a laser emission module (12);
an input end of the drive module (11) is connected to an input end of the analog emission unit (10);
a first end of the laser emission module (12) is connected to an output end of the drive module (11), and a second end of the laser emission module (12) is configured to access a first preset voltage; or
the first end of the laser emission module (12) is connected to a positive output end of the drive module (11), and the second end of the laser emission module (12) is connected to a negative output end of the drive module (11) to access a differential signal output by the drive module (11).

3. The laser transmission circuit according to claim 2, wherein:
the laser emission module (12) comprises a laser emission tube (D1) and a first resistor (R1);
one end of the first resistor (R1) is connected to the first end of the laser emission module (12), and another end of the first resistor (R1) is connected to the second end of the laser emission module (12) through the laser emission tube (D1); or
the first end of the laser emission tube (D1) is connected to the first end of the laser emission module (12), and another end of the laser emission tube (D1) is connected to the second end of the laser emission module (12) through the first resistor (R1).

4. The laser transmission circuit according to claim 3, wherein:
in response to that the first end of the laser emission tube (D1) is connected to the first end of the laser emission module (12) and another end of the laser emission tube (D1) is connected to the second end of the laser emission module (12) through the first resistor (R1), a connection point between the laser emission tube (D1) and the first resistor (R1) is an end F; the drive module (11) comprises a first amplifier circuit (11A), and the first amplifier circuit (11A) is provided with a non-inverting input end and an inverting input end;
the input analog electrical signal is a single-ended signal, the non-inverting input end or the inverting input end of the first amplifier circuit (11A) is connected to the input analog signal through a third resistor, a second input end of the first amplifier circuit (11A) is further connected to an output end of the first amplifier circuit (11A) or the end F through a fourth resistor; or
the input analog electrical signal is a differential signal, the non-inverting input end of the first amplifier circuit (11A) is accessed to the input analog signal through a fifth resistor, the inverting input end of the first amplifier circuit (11A) is accessed to the input analog signal through a sixth resistor, and the non-inverting input end is accessed to a reference voltage through a seventh resistor.

5. The laser transmission circuit according to claim 1, wherein:
the digital emission unit (20) comprises a first low-pass filter unit (21), a first main control unit (22) and a digital emission module (23); and
an input end of the first low-pass filter unit (21) is the input end of the digital emission unit (20), and an output end of the first low-pass filter unit (21) is connected to a controlled end of the digital emission module (23) through the first main control unit (22).

6. The laser transmission circuit according to claim 5, wherein the first main control unit (22) comprises a first main controller (22B) and a first analog-to-digital conversion module (22A), and the first low-pass filter unit (21) is connected to the controlled end of the digital emission module (23) through the first main controller (22B) and the first analog-to-digital conversion module (22A).

7. The laser transmission circuit according to claim 1, wherein:
the receiving unit (30) comprises:
an analog receiving unit (31) configured to receive the analog laser signal and output the analog electrical signal;
a digital receiving unit (32) configured to receive the digital signal and output the digital electrical signal; and
a signal processing unit (33),
a first input end of the signal processing unit (33) is connected to an output end of the analog receiving unit (31) and a second input end of the signal processing unit (33) is connected to an output end of the digital receiving unit (32), the signal processing unit (33) is configured to perform signal process on the accessed analog electrical signal and the digital electrical signal, and output a low-frequency correction signal to a feedback end of the analog receiving unit (31);
the analog receiving unit (31) is further configured to correct a low-frequency operating point according to the received low-frequency correction signal, and output an analog electrical signal corresponding to the corrected low-frequency operating point.

8. The laser transmission circuit according to claim 7, wherein:
the analog receiving unit (31) comprises a laser receiving tube (D2), a second resistor (R2), and a second amplifier circuit (A2),
a first electrode of the laser receiving tube (D2) is configured to access a second preset voltage (RER2), a second electrode of the laser receiving tube (D2) is connected to a first input end of the second amplifier circuit (A2), the second electrode of the laser receiving tube (D2) is further connected to a third preset voltage (RER3) through the second resistor (R2), a second input end of the second amplifier circuit (A2) is a feedback end of the analog receiving unit (31), and an output end of the second amplifier circuit (A2) is the output end of the analog receiving unit (31); or
the first electrode of the laser receiving tube (D2) is configured to access a fourth preset voltage (RER4), the second electrode of the laser receiving tube (D2) is connected to a second input end of the second amplifier circuit (A2), the second electrode of the laser receiving tube (D2) is further connected to the output end of the second amplifier circuit (A2) through the second resistor (R2), the first input end of the second amplifier circuit (A2) is the feedback end of the analog receiving unit (31), and the output end of the second amplifier circuit (A2) is the output end of the analog receiving unit (31).

9. The laser transmission circuit according to claim 7, wherein:
the signal processing unit (33) comprises a second low-pass filter unit (33A), a second main control unit, and a comparison circuit (33B); and
an input end of the second low-pass filter unit (33A) is the first input end of the signal processing unit (33), the output end of the second low-pass filter unit (33A) is connected to a first input end of the comparison circuit (33B), and an input end of the second main control unit is the second input end of the signal processing unit (33), an output end of the second main control unit is connected to a second input end of the comparison circuit (33B), and an output end of the comparison circuit (33B) is connected to the feedback end of the analog receiving unit (31).

10. The laser transmission circuit according to claim 9, wherein:
the comparison circuit (33B) comprises a third amplifier circuit (A3), a non-inverting input end of the third amplifier circuit (A3) is the first input end of the comparison circuit (33B), and a second input end of the third amplifier circuit (A3) is the second input end of the comparison circuit (33B); or, the second input end of the third amplifier circuit (A3) is the first input end of the comparison circuit (33B), and the non-inverting end of the third amplifier circuit (A3) is the second input end of the third amplifier circuit (A3); and
the signal processing unit (33) further comprises a capacitor circuit (33E) connected between the first input end and the output end of the comparison circuit (33B).

11. The laser transmission circuit according to claim 9, wherein the signal processing unit (33) comprises a third low-pass filter unit (33F), and the output end of the comparison circuit (33B) is connected to the feedback end of the analog receiving unit (31) through the third low-pass filter unit (33F).

12. The laser transmission circuit according to claim 9, wherein:
the second main control unit comprises a second main controller (33C) and a first digital-to-analog conversion module (33D); and
an input end of the second main controller (33C) is the input end of the second main control unit, an output end of the second main controller (33C) is connected to an input end of the digital-to-analog conversion module, and an output end of the first digital-to-analog conversion module (33D) is the output end of the second main control unit.

13. The laser transmission circuit according to claim 7, wherein:
the signal processing unit (33) comprises a fourth low-pass filter unit (33G) and a third main control unit;
an input end of the fourth low-pass filter unit (33G) is the first input end of the signal processing unit (33), and an output end of the fourth low-pass filter unit (33G) is connected to a first input end of the third main control unit, a second input end of the third main control unit is a second input end of the signal processing unit (33), and an output end of the third main control unit is an output end of the signal processing unit (33);
the third main control unit comprises a second analog-to-digital conversion module (33H), a third main controller (331), and a second digital-to-analog conversion module (33J); and
the third main controller (331) is connected to the output end of the digital receiving unit (32), the third main controller (331) is further connected to an output end of the fourth low-pass filter unit (33G) through the second analog-to-digital conversion module (33H), and the third main controller (331) is further connected to the feedback end of the analog receiving unit (31) through the second digital-to-analog conversion module (33J).

14. The laser transmission circuit according to claim 7, wherein:
the digital emission module (23) is a laser transmitter, and the digital receiving unit (32) is a laser receiver; or
the digital emission module (23) is a wireless transmitting circuit, and the digital receiving unit (32) is a wireless receiving circuit; or
the digital emission module (23) is an opto-coupler unit, and the digital receiving unit (32) is a main controller; or
the digital emission module (23) is the main controller, and the digital receiving unit (32) is the opto-coupler unit.

15. A laser transmission component, **characterized by** comprising the laser transmission circuit according to any one of claims 1 to 14.

## Patentansprüche

1. Schaltungsanordnung zur Laserübertragung, **dadurch gekennzeichnet, dass** sie umfasst:
eine analoge Sendeeinheit (10); eine digitale Sendeeinheit (20); und eine Empfangseinheit (30), wobei: die analoge Sendeeinheit (10) einen Eingang umfasst, der dazu ausgebildet ist, ein analoges elektrisches Eingangssignal der Laserübertragungsschaltung zu empfangen, und dazu ausgebildet ist, ein analoges Lasersignal auszusenden, das dem analogen Eingangssignal entspricht; die digitale Sendeeinheit (20) einen Eingang umfasst, der dazu ausgebildet ist, das analoge elektrische Eingangssignal der Laserübertragungsschaltung zu empfangen, und dazu ausgebildet ist, ein digitales Signal auszusenden, das einer Niederfrequenzkomponente des analogen Eingangssignals entspricht; die Empfangseinheit (30) dazu ausgebildet ist, das von der analogen Sendeeinheit (10) ausgegebene analoge Lasersignal und das von der digitalen Sendeeinheit (20) ausgegebene digitale Signal zu empfangen und ein analoges elektrisches Signal entsprechend dem analogen Lasersignal sowie ein digitales elektrisches Signal entsprechend dem digitalen Signal zu erzeugen; und die Empfangseinheit (30) ferner dazu ausgebildet ist, das erzeugte analoge elektrische Signal anhand des erzeugten digitalen elektrischen Signals zu korrigieren und das korrigierte analoge elektrische Signal auszugeben.

2. Schaltungsanordnung nach Anspruch 1, **dadurch gekennzeichnet, dass**: die analoge Sendeeinheit (10) ein Treibermodul (11) und ein Lasersendermodul (12) umfasst: ein Eingang des Treibermoduls (11) mit einem Eingang der analogen Sendeeinheit (10) verbunden ist; ein erster Anschluss des Lasersendermoduls (12) mit einem Ausgang des Treibermoduls (11) verbunden ist und ein zweiter Anschluss des Lasersendermoduls (12) dazu ausgebildet ist, an eine erste vorgegebene Spannung angeschlossen zu werden; oder der erste Anschluss des Lasersendermoduls (12) mit einem positiven Ausgang des Treibermoduls (11) verbunden ist und der zweite Anschluss des Lasersendermoduls (12) mit einem negativen Ausgang des Treibermoduls (11) verbunden ist, um ein vom Treibermodul (11) ausgegebenes Differenzsignal zuzuführen.

3. Schaltungsanordnung nach Anspruch 2, **dadurch gekennzeichnet, dass**: das Lasersendermodul (12) eine Lasersenderröhre (D1) und einen ersten Widerstand (R1) umfasst; ein Ende des ersten Widerstands (R1) mit dem ersten Anschluss des Lasersendermoduls (12) verbunden ist und das andere Ende des ersten Widerstands (R1) über die Lasersenderröhre (D1) mit dem zweiten Anschluss des Lasersendermoduls (12) verbunden ist; oder ein erster Anschluss der Lasersenderröhre (D1) mit dem ersten Anschluss des Lasersendermoduls (12) verbunden ist und ein anderer Anschluss der Lasersenderröhre (D1) über den ersten Widerstand (R1) mit dem zweiten Anschluss des Lasersendermoduls (12) verbunden ist.

4. Schaltungsanordnung nach Anspruch 3, **dadurch gekennzeichnet, dass**: wenn der erste Anschluss der Lasersenderröhre (D1) mit dem ersten Anschluss des Lasersendermoduls (12) verbunden ist und der andere Anschluss der Lasersenderröhre (D1) über den ersten Widerstand (R1) mit dem zweiten Anschluss des Lasersendermoduls (12) verbunden ist, ein Verbindungspunkt zwischen der Lasersenderröhre (D1) und dem ersten Widerstand (R1) ein Ende F ist; das Treibermodul (11) eine erste Verstärkerschaltung (11A) umfasst und die erste Verstärkerschaltung (11A) einen nichtinvertierenden Eingang und einen invertierenden Eingang aufweist; das analoge Eingangssignal ein unsymmetrisches Signal ist, wobei der nichtinvertierende Eingang oder der invertierende Eingang der ersten Verstärkerschaltung (11A) über einen dritten Widerstand mit dem Eingangssignal verbunden ist und ein zweiter Eingang der ersten Verstärkerschaltung (11A) ferner über einen vierten Widerstand mit dem Ausgang der ersten Verstärkerschaltung (11A) oder dem Ende F verbunden ist; oder das analoge Eingangssignal ein Differenzsignal ist, wobei der nichtinvertierende Eingang der ersten Verstärkerschaltung (11A) über einen fünften Widerstand mit dem Eingangssignal verbunden ist, der invertierende Eingang der ersten Verstärkerschaltung (11A) über einen sechsten Widerstand mit dem Eingangssignal verbunden ist und der nichtinvertierende Eingang über einen siebten Widerstand mit einer Referenzspannung verbunden ist.

5. Schaltungsanordnung nach Anspruch 1, **dadurch gekennzeichnet, dass**: die digitale Sendeeinheit (20) eine erste Tiefpassfiltereinheit (21), eine erste Steuereinheit (22) und ein digitales Sendemodul (23) umfasst; und ein Eingang der ersten Tiefpassfiltereinheit (21) der Eingang der digitalen Sendeeinheit (20) ist und ein Ausgang der ersten Tiefpassfiltereinheit (21) über die erste Steuereinheit (22) mit einem gesteuerten Eingang des digitalen Sendemoduls (23) verbunden ist.

6. Schaltungsanordnung nach Anspruch 5, **dadurch gekennzeichnet, dass** die erste Steuereinheit (22) eine erste Hauptsteuereinheit (22B) und ein erstes Analog-Digital-Umsetzmodul (22A) umfasst und die erste Tiefpassfiltereinheit (21) über die erste Hauptsteuereinheit (22B) und das erste Analog-Digital-Umsetzmodul (22A) mit dem gesteuerten Eingang des digitalen Sendemoduls (23) verbunden ist.

7. Schaltungsanordnung nach Anspruch 1, **dadurch gekennzeichnet, dass**: die Empfangseinheit (30) umfasst: eine analoge Empfangseinheit (31), die dazu ausgebildet ist, das analoge Lasersignal zu empfangen und das analoge elektrische Signal auszugeben; eine digitale Empfangseinheit (32), die dazu ausgebildet ist, das digitale Signal zu empfangen und das digitale elektrische Signal auszugeben; und eine Signalverarbeitungseinheit (33), wobei ein erster Eingang der Signalverarbeitungseinheit (33) mit einem Ausgang der analogen Empfangseinheit (31) und ein zweiter Eingang der Signalverarbeitungseinheit (33) mit einem Ausgang der digitalen Empfangseinheit (32) verbunden ist, die Signalverarbeitungseinheit (33) dazu ausgebildet ist, das zugeführte analoge elektrische Signal und das digitale elektrische Signal zu verarbeiten und ein Niederfrequenz-Korrektursignal an einen Rückkopplungseingang der analogen Empfangseinheit (31) auszugeben; die analoge Empfangseinheit (31) ferner dazu ausgebildet ist, einen Niederfrequenz-Arbeitspunkt anhand des empfangenen Korrektursignals zu korrigieren und ein analoges elektrisches Signal entsprechend dem korrigierten Arbeitspunkt auszugeben.

8. Lasersendeschaltung nach Anspruch 7, wobei: die analoge Empfangseinheit (31) eine Laserempfangsröhre (D2), einen zweiten Widerstand (R2) und eine zweite Verstärkerschaltung (A2) umfasst, eine erste Elektrode der Laserempfangsröhre (D2) so ausgelegt ist, dass sie auf eine zweite voreingestellte Spannung (RER2) zugreift, eine zweite Elektrode der Laserempfangsröhre (D2) mit einem ersten Eingangsende der zweiten Verstärkerschaltung (A2) verbunden ist, die zweite Elektrode der Laserempfangsröhre (D2) ferner über den zweiten Widerstand (R2) mit einer dritten voreingestellten Spannung (RER3) verbunden ist, ein zweites Eingangsende der zweiten Verstärkerschaltung (A2) ein Rückkopplungsende der analogen Empfangseinheit (31) ist, und ein Ausgangsende der zweiten Verstärkerschaltung (A2) ist das Ausgangsende der analogen Empfangseinheit (31); oder die erste Elektrode der Laserempfangsröhre (D2) ist so konfiguriert, dass sie auf eine vierte voreingestellte Spannung (RER4) zugreift, die zweite Elektrode der Laserempfangsröhre (D2) ist mit einem zweiten Eingangsende der zweiten Verstärkerschaltung (A2) verbunden, die zweite Elektrode der Laserempfangsröhre (D2) ist ferner über den zweiten Widerstand (R2) mit dem Ausgangsende der zweiten Verstärkerschaltung (A2) verbunden, das erste Eingangsende der zweiten Verstärkerschaltung (A2) ist das Rückkopplungsende der analogen Empfangseinheit (31), und das Ausgangsende der zweiten Verstärkerschaltung (A2) ist das Ausgangsende der analogen Empfangseinheit (31).

9. Schaltungsanordnung nach Anspruch 7, **dadurch gekennzeichnet, dass**: die Signalverarbeitungseinheit (33) eine zweite Tiefpassfiltereinheit (33A), eine zweite Hauptsteuereinheit und eine Vergleichsschaltung (33B) umfasst; und ein Eingang der zweiten Tiefpassfiltereinheit (33A) der erste Eingang der Signalverarbeitungseinheit (33) ist, der Ausgang der zweiten Tiefpassfiltereinheit (33A) mit einem ersten Eingang der Vergleichsschaltung (33B) verbunden ist, ein Eingang der zweiten Hauptsteuereinheit der zweite Eingang der Signalverarbeitungseinheit (33) ist, ein Ausgang der zweiten Hauptsteuereinheit mit einem zweiten Eingang der Vergleichsschaltung (33B) verbunden ist und ein Ausgang der Vergleichsschaltung (33B) mit dem Rückkopplungseingang der analogen Empfangseinheit (31) verbunden ist.

10. Laserübertragungsschaltung nach Anspruch 9, **dadurch gekennzeichnet, dass** die Vergleichsschaltung (33B) eine dritte Verstärkerschaltung (A3) umfasst, wobei ein nichtinvertierender Eingangsanschluss der dritten Verstärkerschaltung (A3) der erste Eingangsanschluss der Vergleichsschaltung (33B) ist und ein zweiter Eingangsanschluss der dritten Verstärkerschaltung (A3) der zweite Eingangsanschluss der Vergleichsschaltung (33B) ist; oder das zweite Eingangsende der dritten Verstärkerschaltung (A3) das erste Eingangsende der Vergleichsschaltung (33B) ist und das nichtinvertierende Ende der dritten Verstärkerschaltung (A3) das zweite Eingangsende der dritten Verstärkerschaltung (A3) ist; und die Signalverarbeitungseinheit (33) ferner eine Kondensatorschaltung (33E) umfasst, die zwischen dem ersten Eingangsende und dem Ausgangsende der Vergleichsschaltung (33B) angeschlossen ist.

11. Schaltungsanordnung nach Anspruch 9, **dadurch gekennzeichnet, dass** die Signalverarbeitungseinheit (33) eine dritte Tiefpassfiltereinheit (33F) umfasst und der Ausgang der Vergleichsschaltung (33B) über die dritte Tiefpassfiltereinheit (33F) mit dem Rückkopplungseingang der analogen Empfangseinheit (31) verbunden ist.

12. Schaltungsanordnung nach Anspruch 9, **dadurch gekennzeichnet, dass**: die zweite Hauptsteuereinheit eine zweite Hauptsteuereinheit (33C) und ein erstes Digital-Analog-Umsetzmodul (33D) umfasst; und ein Eingang der zweiten Hauptsteuereinheit (33C) der Eingang der zweiten Hauptsteuereinheit ist, ein Ausgang der zweiten Hauptsteuereinheit (33C) mit einem Eingang des Digital-Analog-Umsetzmoduls verbunden ist und der Ausgang des ersten Digital-Analog-Umsetzmoduls (33D) der Ausgang der zweiten Hauptsteuereinheit ist.

13. Schaltungsanordnung nach Anspruch 7, **dadurch gekennzeichnet, dass** die Signalverarbeitungseinheit (33) eine vierte Tiefpassfiltereinheit (33G) und eine dritte Hauptsteuereinheit umfasst; ein Eingangsende der vierten Tiefpassfiltereinheit (33G) das erste Eingangsende der Signalverarbeitungseinheit (33) ist, und ein Ausgangsende der vierten Tiefpassfiltereinheit (33G) mit einem ersten Eingangsende der dritten Hauptsteuereinheit verbunden ist, ein zweites Eingangsende der dritten Hauptsteuereinheit ein zweites Eingangsende der Signalverarbeitungseinheit (33) ist und ein Ausgangsende der dritten Hauptsteuereinheit ein Ausgangsende der Signalverarbeitungseinheit (33) ist; die dritte Hauptsteuereinheit umfasst ein zweites Analog-Digital-Wandlermodul (33H), eine dritte Hauptsteuerung (33I) und ein zweites Digital-Analog-Wandlermodul (33J); und die dritte Hauptsteuerung (33I) ist mit dem Ausgang der digitalen Empfangseinheit (32) verbunden, die dritte Hauptsteuereinheit (33I) ist ferner über das zweite Analog-Digital-Wandlermodul (33H) mit einem Ausgangsende der vierten Tiefpassfiltereinheit (33G) verbunden, und die dritte Hauptsteuereinheit (33I) ist ferner über das zweite Digital-Analog-Wandlermodul (33J) mit dem Rückkopplungsende der analogen Empfangseinheit (31) verbunden.

14. Schaltungsanordnung nach Anspruch 7, **dadurch gekennzeichnet, dass**: das digitale Sendemodul (23) ein Lasersender ist und die digitale Empfangseinheit (32) ein Laserempfänger ist; oder das digitale Sendemodul (23) eine drahtlose Sendeschaltung ist und die digitale Empfangseinheit (32) eine drahtlose Empfangsschaltung ist; oder das digitale Sendemodul (23) eine Optokopplereinheit ist und die digitale Empfangseinheit (32) eine Hauptsteuereinheit ist; oder das digitale Sendemodul (23) die Hauptsteuereinheit ist und die digitale Empfangseinheit (32) eine Optokopplereinheit ist.

15. Laserübertragungskomponente, **dadurch gekennzeichnet, dass** sie die Laserübertragungsschaltung nach einem der Ansprüche 1 bis 14 umfasst.

## Revendications

1. Circuit de transmission laser, **caractérisé en ce qu'**il comprend: une unité d'émission analogique (10); une unité d'émission numérique (20); et une unité de réception (30), dans lequel: l'unité d'émission analogique (10) comprend une extrémité d'entrée configurée pour recevoir un signal électrique analogique d'entrée du circuit de transmission laser, et est configurée pour émettre un signal laser analogique correspondant au signal électrique analogique d'entrée l'unité d'émission numérique (20) comprend une extrémité d'entrée configurée pour recevoir le signal électrique analogique d'entrée du circuit de transmission laser, et est configurée pour émettre un signal numérique correspondant à une composante basse fréquence du signal électrique analogique d'entrée; l'unité de réception (30) est configurée pour recevoir le signal laser analogique émis par l'unité d'émission analogique (10) et le signal numérique émis par l'unité d'émission numérique (20), et générer un signal électrique analogique correspondant au signal laser analogique et un signal électrique numérique correspondant au signal numérique; et l'unité de réception (30) est en outre configurée pour corriger le signal électrique analogique généré selon le signal électrique numérique généré, et pour émettre le signal électrique analogique corrigé.

2. Circuit de transmission laser selon la revendication 1, dans lequel:I 'unité d'émission analogique (10) comprend un module de commande (11) et un module d'émission laser (12); une extrémité d'entrée du module de commande (11) est connectée à une extrémité d'entrée de l'unité d'émission analogique (10); une première extrémité du module d'émission laser (12) est connectée à une extrémité de sortie du module de commande (11), et une seconde extrémité du module d'émission laser (12) est configurée pour accéder à une première tension prédéterminée; ou la première extrémité du module d'émission laser (12) est connectée à une sortie positive du module de commande (11), et la seconde extrémité du module d'émission laser (12) est connectée à une sortie négative du module de commande (11) pour accéder à un signal différentiel émis par le module de commande (11).

3. Circuit de transmission laser selon la revendication 2, dans lequel : le module d'émission laser (12) comprend un tube laser (D1) et une première résistance (R1); une extrémité de la première résistance (R1) est connectée à la première extrémité du module d'émission laser (12), et l'autre extrémité de la première résistance (R1) est connectée à la seconde extrémité du module d'émission laser (12) par l'intermédiaire du tube laser (D1); ou la première extrémité du tube laser (D1) est connectée à la première extrémité du module d'émission laser (12), et l'autre extrémité du tube laser (D1) est connectée à la seconde extrémité du module d'émission laser (12) par l'intermédiaire de la première résistance (R1).

4. Circuit de transmission laser selon la revendication 3, dans lequel: en réponse au fait que la première extrémité du tube laser (D1) est connectée à la première extrémité du module d'émission laser (12) et que l'autre extrémité du tube laser (D1) est connectée à la seconde extrémité du module d'émission laser (12) par l'intermédiaire de la première résistance (R1), un point de connexion entre le tube laser (D1) et la première résistance (R1) est une extrémité F; le module de commande (11) comprend un premier circuit amplificateur (11A), et le premier circuit amplificateur (11A) est doté d'une entrée non inverseuse et d'une entrée inverseuse; le signal électrique analogique d'entrée est un signal à extrémité unique, l'entrée non inverseuse ou l'entrée inverseuse du premier circuit amplificateur (11A) est connectée au signal analogique d'entrée par une troisième résistance, une seconde entrée du premier circuit amplificateur (11A) est en outre connectée à une sortie du premier circuit amplificateur (11A) ou à l'extrémité F par une quatrième résistance; ou le signal électrique analogique d'entrée est un signal différentiel, l'entrée non inverseuse du premier circuit amplificateur (11A) est connectée au signal analogique d'entrée par une cinquième résistance, l'entrée inverseuse du premier circuit amplificateur (11A) est connectée au signal analogique d'entrée par une sixième résistance, et l'entrée non inverseuse est connectée à une tension de référence par une septième résistance.

5. Circuit de transmission laser selon la revendication 1, dans lequel: l'unité d'émission numérique (20) comprend une première unité de filtre passe-bas (21), une première unité de contrôle principal (22) et un module d'émission numérique (23); et une extrémité d'entrée de la première unité de filtre passe-bas (21) constitue l'extrémité d'entrée de l'unité d'émission numérique (20), et une extrémité de sortie de la première unité de filtre passe-bas (21) est connectée à une extrémité contrôlée du module d'émission numérique (23) par l'intermédiaire de la première unité de contrôle principal (22).

6. Le circuit de transmission laser selon la revendication 5, dans lequel la première unité de commande principale (22) comprend un premier contrôleur principal (22B) et un premier module de conversion analogique-numérique (22A), et la première unité de filtrage passe-bas (21) est connectée à l'extrémité contrôlée du module d'émission numérique (23) par l'intermédiaire du premier contrôleur principal (22B) et du premier module de conversion analogique-numérique (22A).

7. Le circuit de transmission laser selon la revendication 1, dans lequel: l'unité de réception (30) comprend:
une unité de réception analogique (31) configurée pour recevoir le signal laser analogique et fournir le signal électrique analogique;
une unité de réception numérique (32) configurée pour recevoir le signal numérique et fournir le signal électrique numérique; et
une unité de traitement du signal (33), le premier terminal d'entrée de l'unité de traitement du signal (33) est connecté à la sortie de l'unité de réception analogique (31) et le deuxième terminal d'entrée de l'unité de traitement du signal (33) est connecté à la sortie de l'unité de réception numérique (32), l'unité de traitement du signal (33) est configurée pour traiter le signal électrique analogique et le signal électrique numérique reçus et fournir un signal de correction basse fréquence à un terminal de rétroaction de l'unité de réception analogique (31); l'unité de réception analogique (31) est en outre configurée pour corriger un point de fonctionnement basse fréquence selon le signal de correction basse fréquence reçu, et fournir un signal électrique analogique correspondant au point de fonctionnement basse fréquence corrigé.

8. Le circuit de transmission laser selon la revendication 7, dans lequel: l'unité de réception analogique (31) comprend un tube récepteur laser (D2), une deuxième résistance (R2) et un deuxième circuit amplificateur (A2), le premier électrode du tube récepteur laser (D2) est configuré pour recevoir une deuxième tension prédéfinie (RER2), le deuxième électrode du tube récepteur laser (D2) est connecté au premier terminal d'entrée du deuxième circuit amplificateur (A2), le deuxième électrode du tube récepteur laser (D2) est en outre connecté à une troisième tension prédéfinie (RER3) via la deuxième résistance (R2), le deuxième terminal d'entrée du deuxième circuit amplificateur (A2) est un terminal de rétroaction de l'unité de réception analogique (31), et la sortie du deuxième circuit amplificateur (A2) est la sortie de l'unité de réception analogique (31); ou le premier électrode du tube récepteur laser (D2) est configuré pour recevoir une quatrième tension prédéfinie (RER4), le deuxième électrode du tube récepteur laser (D2) est connecté au deuxième terminal d'entrée du deuxième circuit amplificateur (A2), le deuxième électrode du tube récepteur laser (D2) est en outre connecté à la sortie du deuxième circuit amplificateur (A2) via la deuxième résistance (R2), le premier terminal d'entrée du deuxième circuit amplificateur (A2) est le terminal de rétroaction de l'unité de réception analogique (31), et la sortie du deuxième circuit amplificateur (A2) est la sortie de l'unité de réception analogique (31).

9. Le circuit de transmission laser selon la revendication 7, dans lequel: l'unité de traitement du signal (33) comprend une deuxième unité de filtrage passe-bas (33A), une deuxième unité de commande principale et un circuit de comparaison (33B); et l'entrée de la deuxième unité de filtrage passe-bas (33A) est le premier terminal d'entrée de l'unité de traitement du signal (33), la sortie de la deuxième unité de filtrage passe-bas (33A) est connectée au premier terminal d'entrée du circuit de comparaison (33B), et l'entrée de la deuxième unité de commande principale est le deuxième terminal d'entrée de l'unité de traitement du signal (33), la sortie de la deuxième unité de commande principale est connectée au deuxième terminal d'entrée du circuit de comparaison (33B), et la sortie du circuit de comparaison (33B) est connectée au terminal de rétroaction de l'unité de réception analogique (31).

10. Le circuit de transmission laser selon la revendication 9, dans lequel : le circuit de comparaison (33B) comprend un troisième circuit amplificateur (A3), l'entrée non inverseuse du troisième circuit amplificateur (A3) est le premier terminal d'entrée du circuit de comparaison (33B), et le deuxième terminal d'entrée du troisième circuit amplificateur (A3) est le deuxième terminal d'entrée du circuit de comparaison (33B) ; ou le deuxième terminal d'entrée du troisième circuit amplificateur (A3) est le premier terminal d'entrée du circuit de comparaison (33B), et l'entrée non inverseuse du troisième circuit amplificateur (A3) est le deuxième terminal d'entrée du troisième circuit amplificateur (A3); et l'unité de traitement du signal (33) comprend en outre un circuit capacitif (33E) connecté entre le premier terminal d'entrée et la sortie du circuit de comparaison (33B).

11. Le circuit de transmission laser selon la revendication 9, dans lequel l'unité de traitement du signal (33) comprend une troisième unité de filtrage passe-bas (33F), et la sortie du circuit de comparaison (33B) est connectée au terminal de rétroaction de l'unité de réception analogique (31) via la troisième unité de filtrage passe-bas (33F).

12. Le circuit de transmission laser selon la revendication 9, dans lequel: la deuxième unité de commande principale comprend un deuxième contrôleur principal (33C) et un premier module de conversion numérique-analogique (33D); et l'entrée du deuxième contrôleur principal (33C) est l'entrée de la deuxième unité de commande principale, la sortie du deuxième contrôleur principal (33C) est connectée à l'entrée du module de conversion numérique-analogique, et la sortie du premier module de conversion numérique-analogique (33D) est la sortie de la deuxième unité de commande principale.

13. Le circuit de transmission laser selon la revendication 7, dans lequel: l'unité de traitement du signal (33) comprend une quatrième unité de filtrage passe-bas (33G) et une troisième unité de commande principale; l'entrée de la quatrième unité de filtrage passe-bas (33G) est le premier terminal d'entrée de l'unité de traitement du signal (33), et la sortie de la quatrième unité de filtrage passe-bas (33G) est connectée au premier terminal d'entrée de la troisième unité de commande principale, le deuxième terminal d'entrée de la troisième unité de commande principale est le deuxième terminal d'entrée de l'unité de traitement du signal (33), et la sortie de la troisième unité de commande principale est la sortie de l'unité de traitement du signal (33); la troisième unité de commande principale comprend un deuxième module de conversion analogique-numérique (33H), un troisième contrôleur principal (33I) et un deuxième module de conversion numérique-analogique (33J); et le troisième contrôleur principal (33I) est connecté à la sortie de l'unité de réception numérique (32), le troisième contrôleur principal (33I) est en outre connecté à la sortie de la quatrième unité de filtrage passe-bas (33G) via le deuxième module de conversion analogique-numérique (33H), et le troisième contrôleur principal (33I) est en outre connecté au terminal de rétroaction de l'unité de réception analogique (31) via le deuxième module de conversion numérique-analogique (33J).

14. Le circuit de transmission laser selon la revendication 7, dans lequel: le module d'émission numérique (23) est un émetteur laser, et l'unité de réception numérique (32) est un récepteur laser; ou le module d'émission numérique (23) est un circuit de transmission sans fil, et l'unité de réception numérique (32) est un circuit de réception sans fil; ou le module d'émission numérique (23) est une unité optocoupleur, et l'unité de réception numérique (32) est un contrôleur principal; ou le module d'émission numérique (23) est le contrôleur principal, et l'unité de réception numérique (32) est l'unité optocoupleur.

15. Un composant de transmission laser, **caractérisé par le fait qu'**il comprend le circuit de transmission laser selon l'une quelconque des revendications 1 à 14.
